# FASCICULE DE BREVET EUROPEEN

(11) **EP 2 942 147 B1**
(45) Date de publication et mention de la délivrance du brevet: **21.11.2018**
(21) Numéro de dépôt: 14167573.6
(22) Date de dépôt: 08.05.2014
(51) Int. Cl.: B23P 15/00, G04B 15/14, G04D 3/00

(54) **Mécanisme d'échappement d'horlogerie sans lubrification**
Uhrhemmungsmechanismus ohne Schmierung
Clock escapement mechanism without lubrication

(43) Date de publication de la demande: 11.11.2015
(73) Titulaire: Nivarox-FAR S.A., 2400 Le Locle (CH)
(72) Inventeur: Dubois, Philippe, 2074 Marin (CH); Charbon, Christian, 2054 Chézard-St-Martin (CH)
(74) Mandataire: Giraud, Eric

(56) Documents cités:
- EP-A1- 0 732 635
- WO-A1-2009/049591
- KEREN DENG AND WEN H KO: "A study of static friction between silicon and silicon compounds", ELECTRONICS DESIGN CENTER AND DEPARTMENT OF ELECTRICAL ENGINEERING & APPLIED PHYSICS, 15 décembre 1991 (1991-12-15), pages 1-5, XP002734688, UK
- A Stoffel, A Kovács, W Kronast and B Müller: "LPCVD against PECVD for micromechanical applications", , 28 décembre 1995 (1995-12-28), XP002734924, Extrait de l'Internet: URL:http://iopscience.iop.org/0960-1317/6/ 1/001

## Description

### Domaine de l'invention

L'invention concerne un mécanisme d'échappement d'horlogerie à tribologie améliorée, comportant au moins un couple de composants comportant un premier composant et un deuxième composant comportant respectivement une première surface de frottement et une deuxième surface de frottement qui sont agencées pour coopérer en contact l'une avec l'autre, ladite première surface de frottement et ladite deuxième surface frottement comprenant chacune du nitrure de silicium.

L'invention concerne encore un procédé de réalisation d'un tel mécanisme d'échappement.

L'invention concerne le domaine des mécanismes horlogers comportant des composants en permanence en mouvement, et plus particulièrement le domaine des mécanismes d'échappement.

### Arrière-plan de l'invention

Les constructeurs horlogers se sont toujours efforcés d'accroître la fiabilité des mouvements, grâce à la réduction de la fréquence des entretiens, tout en assurant la marche précise des mouvements horlogers.

La lubrification des mobiles et composants en mouvement est un problème difficile à résoudre. De longues expérimentations tribologiques sont nécessaires pour mettre au point des solutions permettant de simplifier ou même de supprimer la lubrification.

Plus particulièrement, on recherche un fonctionnement sans lubrification des mécanismes d'échappement, en tentant de définir des couples de matériaux en frottement présentant un coefficient de frottement bas et stable ainsi qu'une faible usure, et présentant une excellente tenue dans la durée.

Le document EP 0 732 635 A1 au nom de CSEM décrit la fabrication d'un composant de micro-mécanique, notamment d'une ancre d'échappement, avec une surface de frottement comportant du nitrure de silicium, dans une composition non précisée. Ce document envisage un couple avec une contre-pièce, avec une tribologie améliorée : ce document cite le couple nitrure de titane contre carbure de titane, ou le couple nitrure de titane contre carbure de silicium.

Le document XP002734688, « A study of static friction between silicon and silicon compounds », de MM. Deng et Ko, décrit l'utilisation en micro-mécanique de précision du couple nitrure de silicium - silicium, pour une faible usure dans la durée, et une tribologie améliorée.

Le document XP002734924, « LPCVD against PECVD for micromechanical applciations », de MM, Stoffel, Kovacs, Kronast, Müller, décrit l'utilisation de nitrure de silicium non stoechiométrique, obtenu par PECVD ou LPCVD, pour assurer des propriétés tribologiques.

Le document WO2009/049591 au nom de Damasko décrit un procédé de fabrication d'éléments fonctionnels mécaniques de mouvements, en particulier d'éléments fonctionnels pour faire osciller les systèmes de mouvements, dont le matériau ou le matériau de départ est choisi dans un groupe comportant une grande variété de composés, dont le nitrure de silicium.

### Résumé de l'invention

L'invention se propose de fournir une solution à ce problème.

L'invention concerne plus particulièrement l'utilisation du nitrure de silicium comme matériau tribologique à haute performance dans l'échappement.

A cet effet, l'invention concerne un mécanisme d'échappement d'horlogerie à tribologie améliorée, selon la revendication 1.

L'invention concerne encore un procédé de réalisation d'un tel mécanisme d'échappement, caractérisé en ce qu'on réalise chaque couple constitué par une première surface de frottement et une deuxième surface de frottement antagonistes, en réalisant un composant en nitrure de silicium avec un substrat pour constituer ladite première surface de frottement et la deuxième surface de frottement, ou bien par frittage, ou bien par élaboration massive.

### Description sommaire des dessins

D'autres caractéristiques et avantages de l'invention apparaîtront à la lecture de la description détaillée qui va suivre, en référence aux dessins annexés, où :

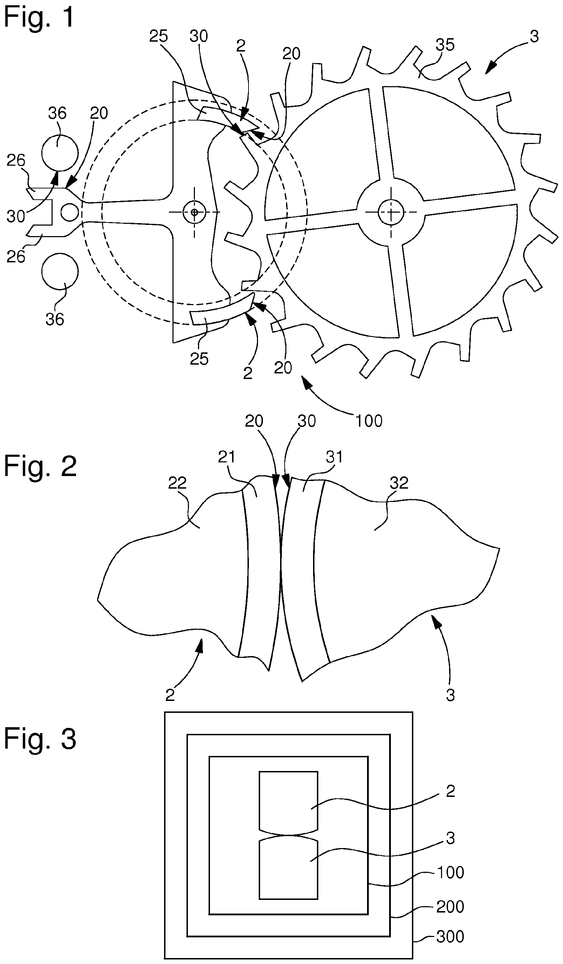

- la figure 1 représente, de façon schématisée et en vue en plan, un mécanisme d'échappement comportant notamment une palette d'ancre coopérant en contact avec une roue d'échappement, au niveau de surfaces de contact agencées selon l'invention ;
- la figure 2 représente, de façon schématisée, la coopération entre les surfaces de contact antagonistes ;
- la figure 3 représente, sous forme d'un schéma-blocs, une pièce d'horlogerie comportant un mouvement lequel comporte un mécanisme d'échappement qui comporte lui-même un couple de composants agencé selon l'invention ;
- la figure 4 est un diagramme représentant, en ordonnée, un coefficient de friction, en fonction de l'inverse d'une pression de contact en abscisse, en GPa⁻¹, pour le couple saphir/Diamond like carbon (ou DLC) selon la courbe supérieure en pointillé, et pour le couple diamant/Diamond like carbon (ou DLC) selon la courbe inférieure en trait interrompu ;
- la figure 5 est un diagramme similaire à celui de la figure 4, pour le couple Si₃N₄/ Nanocrystalline Diamond (ou NCD) ;
- selon la courbe supérieure en trait interrompu, pour le couple Diamond like carbon (ou DLC)/ rubis, selon la courbe en pointillé,
- et pour le couple silicium implanté avec du carbone / rubis selon la courbe intermédiaire en trait interrompu,
- et pour le couple Si₃N₄/Si selon la courbe inférieure presque horizontale en double trait interrompu.

### Description détaillée des modes de réalisation préférés

L'invention concerne l'utilisation du nitrure de silicium en tant que matériau permettant le fonctionnement de l'échappement horloger sans lubrification.

Par commodité de langage, on appellera ci-après « nitrure de silicium » au sens large un matériau qui est composé:
- ou bien par du nitrure de silicium stoechiométrique Si₃N₄, qui peut être massif dans le cas le plus général, ou encore en couche mince ;
- ou bien selon une composition dite non stoechiométrique SiₓN_{y}H_{z}, avec x égal à 1, y compris entre 0.8 et 5.0, et z compris entre 0.00 et 0.70, et plus particulièrement entre 0.04 et 0.70, qui est de préférence appliqué en couche mince, mais qui peut aussi être constitutive d'un composant massif.

On appelle ici « massif » un composant dont la plus petite dimension est supérieure à 0,10 mm, tandis qu'une « couche mince » a sa plus petite dimension inférieure à 10 micromètres, et de préférence inférieure à 1 micromètre.

En effet l'expérimentation permet d'établir que le frottement du nitrure de silicium contre du silicium ou de l'oxyde de silicium présente des propriétés particulièrement souhaitées dans un mécanisme horloger, et tout particulièrement dans le cas d'un mécanisme d'échappement.

Un tel couple de frottement présente un coefficient de frottement bas, inférieur à 0.17, sur une large plage de force - vitesse (1mN - 100mN et 1 cm/s - 10 cm/s).

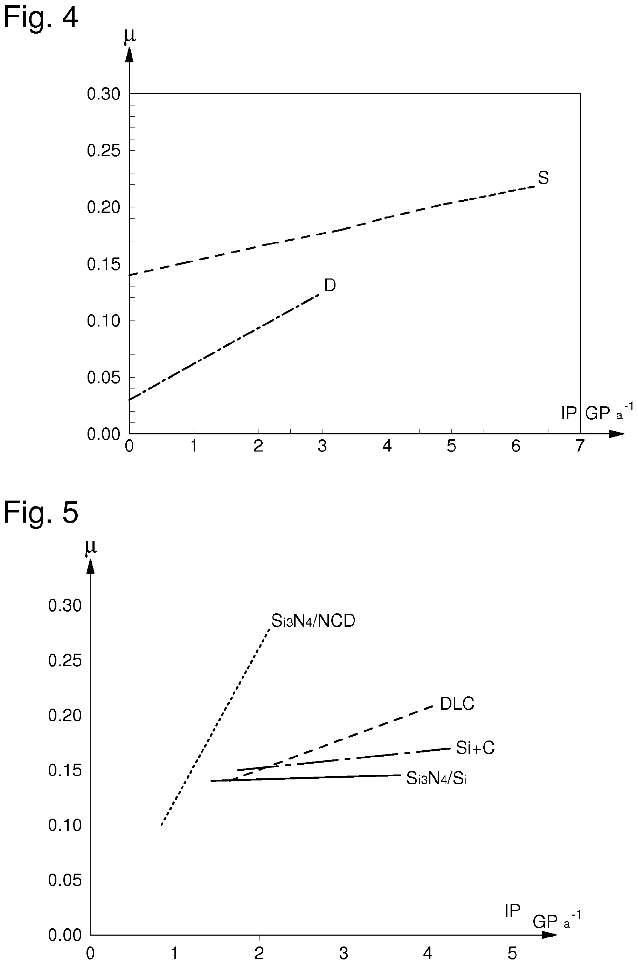

Les travaux des auteurs cités plus bas montrent que, pour des matériaux durs élastiques, en raison de l'augmentation de la contrainte de cisaillement en fonction de la pression, le coefficient de frottement varie habituellement selon la loi illustrée par la figure 4, de type: µ = S/P+α, où : S : contrainte de cisaillement limite, P : pression de Hertz, α : paramètre.

Le paramètre S détermine la dépendance du couple en fonction de la pression, et est de ce fait particulièrement utile à prendre en compte dans le cas du frottement à sec dans l'échappement où les forces et pressions de contact varient grandement.

En comparaison d'autres couples en frottement, les couples nitrure de silicium/Si ou nitrure de silicium/SiO₂ présentent une faible dépendance du coefficient de frottement en fonction de la force normale appliquée, tel que visible sur la figure 5. Cela se traduit par un paramètre S très faible. Ce comportement est particulièrement utile dans l'échappement puisque la force normale varie grandement, typiquement de 0 à 100 mN lors des mises en contact et impacts. Durant les pertes de contact et mises en contact, le nitrure de silicium permet de conserver un coefficient de frottement bas inférieur à 0.2, valeur qui est habituellement considérée comme le seuil critique de fonctionnement de l'échappement.

L'invention concerne donc un mécanisme horloger, et plus particulièrement un mécanisme d'échappement 100 d'horlogerie, à tribologie améliorée en fonction de ces constats.

Ainsi, ce mécanisme d'échappement 100 comporte au moins un couple de composants, comportant un premier composant 2 et un deuxième composant 3, lesquels comportent respectivement une première surface de frottement 20 et une deuxième surface de frottement 30 qui sont agencées pour coopérer en contact l'une avec l'autre.

La première surface de frottement 20 comporte du nitrure de silicium qui est, ou bien du nitrure de silicium stoechiométrique Si₃N₄, ou bien du nitrure de silicium non stoechiométrique SiₓN_{y}H_{z}, avec x égal à 1, y compris entre 0.8 et 5.0, et z compris entre 0.00 et 0.70.

Et la deuxième surface de frottement 30 comporte au moins un matériau à base de silicium pris parmi un groupe comportant le silicium Si, le dioxyde de silicium SiO₂, le silicium amorphe a-Si, le silicium polycristallin p-Si, le silicium poreux, ou un mélange de silicium et d'oxyde de silicium.

On entend ici par « silicium amorphe a-Si » du silicium déposé par procédé PECVD en couche mince, de 50 nm à 10 micromètres, de structure amorphe ; il peut également être hydrogéné ou dopé type N ou type P.

On entend ici par « silicium polycristallin p-Si » du silicium déposé par procédé LPCVD, composé de grains de silicium microcristallin, la taille des grains étant de 10 à 1000 nm ; il peut également être dopé type N ou type P. E est voisin de 160 GPa.

On entend ici par « silicium poreux » un matériau avec une taille de pores de 2nm à 10 micromètres, réalisé selon un procédé de fabrication complexe basé sur une anodisation (électrolyte HF et courant électrique).

De façon propre à l'invention, une au moins de ces première ou deuxième surface de frottement 20, 30, est constituée, ou bien par la surface d'un élément massif en nitrure de silicium massif, de préférence mais non limitativement dans la formulation stoechiométrique Si₃N₄, ou bien par la surface d'une couche mince de préférence mais non limitativement selon une composition non stoechiométrique SiₓN_{y}H_{z}, avec x égal à 1, y compris entre 0.8 et 5.0, et z compris entre 0.00 et 0.70.

Plus particulièrement, z est compris entre 0.04 et 0.70.

De la même façon que la première surface de frottement comportant du nitrure de silicium, la deuxième surface de frottement peut être, ou bien la surface d'un composant massif, ou bien la surface d'une couche mince en nitrure de silicium.

Une application particulièrement intéressante et voisine de l'invention est la coopération de levées en Si₃N₄, en contact avec des roues Si + SiO₂.

Une autre application avantageuse concerne l'application dite « nitrure de silicium massif », avec des roues en Si₃N₄, par exemple découpées ou laser, ou similaire, qui sont en frottement contre une ancre monobloc en Si + SiO₂, ou contre une ancre classique équipée de levées en Si + SiO₂

Les combinaisons utilisables en horlogerie sont notamment :
- roue en SiO₂, sous toutes ses formes, quartz massif SiO₂, Si + SiO₂, coopérant avec des palettes en nitrure de silicium, sous toutes ses formes, en couches minces, ou nitrure de silicium massif ;
- roues nitrure, sous toutes ses formes, Si + nitrure de silicium, nitrure de silicium massif, coopérant avec des palettes en SiO₂, sous toutes ses formes, Si + SiO₂, SiO₂ massif notamment ;
- les palettes peuvent être d'une seule pièce avec l'ancre.

Une application avantageuse concerne une roue en Si oxydé, et des palettes en Si₃N₄ massif, ou encore des palettes en Si oxydé recouvertes de nitrure de silicium.

Selon l'invention, la première surface de frottement 20 et la deuxième surface de frottement 30 comportent chacune du nitrure de silicium.

Dans une mise en oeuvre avantageuse de l'invention, la surface de frottement 20, 30, qui comporte du nitrure de silicium, comporte du nitrure de silicium Si₃N₄, ou encore est constituée de nitrure de silicium Si₃N₄.

Dans une variante particulière, de l'invention la surface de frottement 20, 30, qui comporte du nitrure de silicium est une surface d'une couche de nitrure de silicium d'épaisseur inférieure à 2 micromètres.

De préférence, l'épaisseur d'une telle couche de nitrure de silicium est comprise entre 50 et 1000 nm. Plus particulièrement, cette couche, dite mince, de nitrure de silicium est d'épaisseur comprise entre 50 nanomètres et 500 nanomètres.

Dans une variante particulière de l'invention, la surface de frottement 20, 30, qui comporte du nitrure de silicium est la surface d'une couche de nitrure de silicium, laquelle couche recouvre un substrat constitué de quartz ou de silicium ou d'un oxyde de silicium, ou d'un mélange de silicium et d'oxyde de silicium.

Dans une variante particulière, la surface de frottement 30, 20, antagoniste à celle 20, 30, qui comporte du nitrure de silicium, peut aussi comporter au moins un matériau à base de silicium pris parmi un groupe comportant le silicium Si, le dioxyde de silicium SiO₂, le silicium amorphe a-Si, le silicium polycristallin p-Si, le silicium poreux, et est une surface d'une couche constituée exclusivement d'un ou plusieurs matériaux à base de silicium pris parmi ledit groupe.

Tel que visible sur la figure 5, le couple Si₃N₄/Si donne des résultats particulièrement intéressants, en ce que le couple de frottement est sensiblement constant, et ceci sans nécessiter la moindre lubrification.

En effet, les équations donnant l'allure de la droite moyenne entre les points expérimentaux correspondant aux différents couples de la figure 5 sont :
Y=0.1356X - 0,0068 pour le couple Si₃N₄/ Nanocrystalline Diamond (ou NCD) selon la courbe supérieure en trait interrompu,
Y=0.0288X + 0.0928 pour le couple Diamond like carbon (ou DLC)/ rubis selon la courbe en pointillé,
Y=0.0097X +0.1302 pour le couple silicium dopé au carbone / rubis selon la courbe intermédiaire en trait interrompu,
Y=0.0024X + 0.1362 pour le couple Si₃N₄/Si voisin de l'invention selon la courbe inférieure presque horizontale en double trait interrompu.

L'invention concerne encore un procédé de réalisation d'un tel mécanisme d'échappement 100.

Selon ce procédé, on applique une couche de nitrure de silicium sur un substrat pour constituer les première et deuxième surface de frottement 20, 30, ou bien par un dépôt chimique en phase vapeur assisté par plasma PECVD, ou bien par un dépôt chimique en phase vapeur CVD, ou bien par un dépôt par pulvérisation cathodique « sputtering ».

Plus particulièrement, on réalise un composant en nitrure de silicium avec un substrat pour constituer une des première ou deuxième surface de frottement 20, 30, ou bien par frittage, ou bien par élaboration massive.

On peut notamment utiliser, pour le dépôt d'une couche comportant du nitrure de silicium, ou constituée de nitrure de silicium, une ou plusieurs des technologies connues de l'homme de métier spécialiste des « MEMS » : LPCVD (dépôt chimique en phase vapeur sous basse pression sous-atmosphérique), PECVD (dépôt chimique en phase vapeur assisté par plasma), CVD (dépôt chimique en phase vapeur à pression atmosphérique), ALD (dépôt de couches minces atomiques), « sputtering » (pulvérisation cathodique), implantation ionique, et similaires.

Dans une alternative, on choisit le rapport Si/N compris entre 0.2 à 1.2. Plus particulièrement, la valeur Si/N de 0.4 est stoechiométrique (nitrure de silicium riche en Si, low stress ou compressif SiₓN_{y}H_{z}, selon Gardeniers et al.).

De préférence on choisit une concentration en hydrogène comprise entre 2 à 30% de H.

De préférence, on choisit, de façon non limitative, un substrat habituel en Si.

En ce qui concerne la sous-couche, on peut choisir, de manière non limitative du SiO₂, typiquement dans une épaisseur comprise entre 50 et 2000 nm, ou du poly-Si, SiC, ou similaire.

Les limitations technologiques liées à la déposition du nitrure de silicium sont connues de l'homme de métier dans le domaine des MEMS.

Ainsi, l'épaisseur d'une couche de nitrure de silicium est de préférence comprise entre 50 et 1000nm.

En ce qui concerne l'état de compression du nitrure de silicium, il est connu de l'homme de métier spécialiste des « MEMS » que l'accroissement de la concentration du Si réduit les tensions dans le nitrure de silicium et peut même le rendre compressif. Il est connu que les matériaux présentant un stress compressif favorisent généralement une réduction de l'usure en frottement. Cela correspond à du nitrure de silicium riche en Si.

Pour une bonne mise en oeuvre de l'invention, il importe que la couche de nitrure de silicium adhère bien au substrat, et que les modules d'élasticité des matériaux ne soient pas trop éloignés. La nature des matériaux sous-jacents est de moindre importance. Si la couche de nitrure de silicium dépasse une épaisseur voisine de 100nm, le frottement est déterminé par cette couche de nitrure de silicium.

Des palettes en Si₃N₄ monobloc peuvent être réalisées par les mêmes techniques que celles utilisées pour la fabrication des levées en rubis polycristallin, connues de l'homme du métier.

Par ailleurs, bien que difficilement réalisable à l'heure actuelle, on peut avantageusement considérer du nitrure de silicium massif en frottement contre du Si ou SiO₂, par exemple pour une palette en nitrure de silicium contre une roue en SiO₂.

L'invention présente de nombreux avantages :
- une faible dépendance du coefficient de frottement en fonction de la vitesse de frottement. Particulièrement utile dans le cas de l'échappement puisque la vitesse varie typiquement entre 0 et 3 cm/s.
- un coefficient de frottement stable en fonction de la vitesse et pression réduit le risque d'apparition d'effet stick-slip se traduisant généralement par une dégradation accélérée des matériaux en frottement.
- l'absence de risque de formation d'un troisième corps défavorable au frottement.
- une faible réactivité chimique du nitrure de silicium, particulièrement dans sa forme stoechiométrique Si₃N₄, le rendant peu sensible aux nettoyages, à la dégradation, à l'interaction avec le milieu ambiant.
- une faible usure.

Le nitrure de silicium présente également l'avantage d'une mise en oeuvre facile, particulièrement par revêtement conforme PECVD, notamment sur du silicium ou de l'oxyde de silicium. Ce procédé de dépose est largement connu et répandu dans l'industrie du silicium.

La présente invention permet une utilisation du nitrure de silicium sous différentes formes : dépôt PECVD, CVD, « sputtering », massif, fritté, et autres.

Des applications voisines de l'invention incluent un frottement du nitrure de silicium contre des partenaires non limitatifs tels que : Si, SiO₂, le silicium amorphe a-Si, le silicium polycristallin p-Si, le silicium poreux.

L'homme du métier pourra se référer aux publications suivantes:
[1] : I.L Singer, R.N. Bolster, et al. "Hertzian stress contribution to low friction behavior of thin MoS2 coatings," Applied Physics Letters, Vol. 57, 1990.
[2] : Chromik, R.R., Wahl, K.J.: Friction of microscale contacts on diamond-like carbon nanocomposite coatings. In: Proceedings of the World Tribology Congress III - 2005, pp. 829-830. American Society of Mechanical Engineers, New York, NY,2005.
[3] : P.W. Bridgeman, "shearing phenomena at high pressures particularly in inorganic compounds," Proc. Am. Acad. Arts Sci. 71, 387, 1936.

## Revendications

1. Mécanisme d'échappement (100) d'horlogerie à tribologie améliorée, comportant au moins un couple de composants comportant un premier composant (2) et un deuxième composant (3) comportant respectivement une première surface de frottement (20) et une deuxième surface de frottement (30) qui sont agencées pour coopérer en contact l'une avec l'autre, **caractérisé en ce que** ladite première surface de frottement (20) et ladite deuxième surface de frottement (30) comportent chacune du nitrure de silicium.

2. Mécanisme d'échappement (100) selon la revendication 1, **caractérisé en ce que** ladite première surface de frottement (20) est constituée par la surface d'un élément massif qui est en nitrure de silicium massif dans la formulation stoechiométrique Si₃N₄.

3. Mécanisme d'échappement (100) selon la revendication 1 ou 2, **caractérisé en ce que** ladite deuxième surface de frottement (30) est constituée par la surface d'un élément massif en nitrure de silicium massif.

4. Mécanisme d'échappement (100) selon la revendication 3, **caractérisé en ce que** ladite deuxième surface de frottement (30) est constituée par la surface d'un élément massif en nitrure de silicium massif dans la formulation stoechiométrique Si₃N₄.

5. Mécanisme d'échappement (100) selon la revendication 1, **caractérisé en ce que** une au moins de ladite première surface de frottement (20) et ladite deuxième surface de frottement (30), est constituée par la surface d'une couche mince de préférence selon une composition non stoechiométrique SiₓN_{y}H_{z}, avec x égal à 1, y compris entre 0.8 et 5.0, et z compris entre 0.00 et 0.70.

6. Mécanisme d'échappement (100) selon la revendication 1, **caractérisé en ce que** z est compris entre 0.04 et 0.70.

7. Mouvement d'horlogerie (200) comportant au moins un mécanisme d'échappement (100) selon l'une des revendications 1 à 6.

8. Pièce d'horlogerie (300) comportant au moins un mouvement d'horlogerie (200) selon la revendication 7 et/ou au moins un mécanisme d'échappement (100) selon l'une des revendications 1 à 6.

9. Procédé de réalisation d'un mécanisme d'échappement (100) selon la revendication 1, **caractérisé en ce qu'**on réalise chaque couple constitué par une première surface de frottement (20) et une deuxième surface de frottement (30) antagonistes comportant du nitrure de silicium, et **caractérisé en ce qu'**on réalise un composant en nitrure de silicium avec un substrat pour constituer ladite première surface de frottement (20) et/ou ladite deuxième surface de frottement (30) par frittage.

10. Procédé de réalisation d'un mécanisme d'échappement (100) selon la revendication 1, **caractérisé en ce qu'**on réalise chaque couple constitué par une première surface de frottement (20) et une deuxième surface de frottement (30) antagonistes comportant du nitrure de silicium, et **caractérisé en ce qu'**on réalise un composant en nitrure de silicium avec un substrat pour constituer ladite première surface de frottement (20) et/ou ladite deuxième surface de frottement (30), par élaboration sous forme d'un composant massif dont la plus petite dimension est supérieure à 0,10 mm.

## Patentansprüche

1. Uhren-Hemmungsmechanismus (100) mit verbesserter Tribologie, umfassend mindestens ein Paar Komponenten, das eine erste Komponente (2) und eine zweite Komponente (3) mit jeweils einer ersten Reibfläche (20) und einer zweiten Reibfläche (30) umfasst, die dafür ausgelegt sind, in gegenseitigem Kontakt zusammenzuwirken, **dadurch gekennzeichnet, dass** die erste Reibfläche (20) und die zweite Reibfläche (30) jeweils Siliciumnitrid enthalten.

2. Hemmungsmechanismus (100) nach Anspruch 1, **dadurch gekennzeichnet, dass** die erste Reibfläche (20) von der Oberfläche eines massiven Elements gebildet ist, das aus massivem Siliciumnitrid mit der stöchiometrischen Formel Si₃N₄ hergestellt ist.

3. Hemmungsmechanismus (100) nach Anspruch 1 oder 2, **dadurch gekennzeichnet, dass** die zweite Reibfläche (30) von der Oberfläche eines massiven Elements aus massivem Siliciumnitrid gebildet ist.

4. Hemmungsmechanismus (100) nach Anspruch 3, **dadurch gekennzeichnet, dass** die zweite Reibfläche (30) von der Oberfläche eines massiven Elements aus massivem Siliciumnitrid mit der stöchiometrischen Formel Si3N4 gebildet ist.

5. Hemmungsmechanismus (100) nach Anspruch 1, **dadurch gekennzeichnet, dass** mindestens die erste Reibfläche (20) und die zweite Reibfläche (30) durch die Oberfläche einer dünnen Schicht vorzugsweise mit einer nicht stöchiometrischen Zusammensetzung SiₓN_{y}H_{z} gebildet sind, wobei x gleich 1 ist, y im Bereich von 0,8 bis 5,0 liegt und z im Bereich von 0,00 bis 0,70 liegt.

6. Hemmungsmechanismus (100) nach Anspruch 1, **dadurch gekennzeichnet, dass** z im Bereich von 0,04 bis 0,70 liegt.

7. Uhrwerk (200), umfassend mindestens einen Hemmungsmechanismus (100) nach einem der Ansprüche 1 bis 6.

8. Zeitmessgerät (300), umfassend mindestens ein Uhrwerk (200) nach Anspruch 7 und/oder mindestens einen Hemmungsmechanismus (100) nach einem der Ansprüche 1 bis 6.

9. Verfahren zum Herstellen eines Hemmungsmechanismus (100) nach Anspruch 1, **dadurch gekennzeichnet, dass** jedes Paar hergestellt wird gebildet aus einer ersten Reibfläche (20) und einer zweiten Reibfläche (30), die einander gegenüberliegen und Siliciumnitrid enthalten, und **dadurch gekennzeichnet, dass** eine Komponente aus Siliciumnitrid mit einem Substrat zum Bilden der ersten Reibfläche (20) und/oder der zweiten Reibfläche (30) durch Sintern hergestellt wird.

10. Verfahren zum Herstellen eines Hemmungsmechanismus (100) nach Anspruch 1, **dadurch gekennzeichnet, dass** jedes Paar hergestellt wird gebildet aus einer ersten Reibfläche (20) und einer zweiten Reibfläche (30), die einander gegenüberliegen und Siliciumnitrid enthalten, und **dadurch gekennzeichnet, dass** eine Komponente aus Siliciumnitrid mit einem Substrat zum Bilden der ersten Reibfläche (20) und/oder der zweiten Reibfläche (30) durch Bearbeitung als Vollmaterial, dessen kleinste Abmessung größer als 0,10 mm ist, hergestellt wird.

## Claims

1. Timepiece escapement mechanism (100) with improved tribology, including at least one pair of components including a first component (2) and a second component (3) respectively including a first friction surface (20) and a second friction surface (30) which are arranged to cooperate in contact with each other, **characterized in that** said first friction surface (20) and said second friction surface (30) each include silicon nitride.

2. Escapement mechanism (100) according to claim 1, **characterized in that** said first friction surface (20) is formed by the surface of a solid element which is made of solid silicon nitride in the stoichiometric formulation Si₃N₄.

3. Escapement mechanism (100) according to claim 1 or 2, **characterized in that** said second friction surface (30) is formed by the surface of a solid element made of solid silicon nitride.

4. Escapement mechanism (100) according to claim 3, **characterized in that** said second friction surface (30) is formed by the surface of a solid element made of solid silicon nitride in the stoichiometric formulation Si₃N₄.

5. Escapement mechanism (100) according to claim 1, **characterized in that** at least one of said first friction surface (20) and said second friction surface (30) is formed by the surface of a thin layer preferably in a non-stoichiometric composition SiₓN_{y}H_{z} where x is equal to 1, y is comprised between 0.8 and 5.0 and z is comprised between 0.00 and 0.70.

6. Escapement mechanism (100) according to claim 1, **characterized in that** z is comprised between 0.04 and 0.70.

7. Timepiece movement (200) including at least one escapement mechanism (100) according to any of claims 1 to 6.

8. Timepiece (300) including at least one timepiece movement (200) according to claim 7 and/or at least one escapement mechanism (100) according to any of claims 1 to 6.

9. Method for making an escapement mechanism (100) according to claim 1, **characterized in that** each pair formed by an opposing first friction surface (20) and second friction surface (30) including silicon nitride, and **characterized in that** a silicon nitride component is made with a substrate to form said first friction surface (20) and/or said second friction surface (30) by sintering.

10. Method for making an escapement mechanism (100) according to claim 1, **characterized in that** each pair, formed by an opposing first friction surface (20) and second friction surface (30) including silicon nitride, and **characterized in that** a silicon nitride component is made with a substrate to form said first friction surface (20) and/or said second friction surface (30), by processing in the form of a solid component whose smallest dimension is greater than 0.10 mm.
